# EUROPÄISCHE PATENTANMELDUNG

(11) **EP 4 344 062 A1**
(43) Veröffentlichungstag der Anmeldung: **27.03.2024**
(21) Anmeldenummer: 23196015.4
(22) Anmeldetag: 07.09.2023
(51) Int. Cl.: H03K 3/537

(54) **MARX-GENERATOR MIT FLUIDKÜHLUNG UND GASRAUM FÜR FUNKENSTRECKEN**

(30) Priorität: 15.09.2022 DE 102022003392
(71) Anmelder: Diehl Defence GmbH & Co. KG, 88662 Überlingen (DE)
(72) Erfinder: Urban, Jürgen, 91056 Erlangen (DE); Dommer, Josef, 90451 Nürnberg (DE); Bickes, Christian, 90552 Röthenbach an der Pegnitz (DE); Kadetov, Victor, 90552 Röthenbach an der Pegnitz (DE)
(74) Vertreter: Diehl Patentabteilung

(57) **Zusammenfassung**

Eine Marx-Anordnung (2) mit einem Gehäuse (4), das einen Innenraum (6) umgibt, und mit einem im Innenraum (6) angeordneten Marx-Generator (8), mit mehreren in Reihe geschalteten Kondensatorstufen (10-n), die jeweils mindestens einen ersten (12a) und einen zweiten Spannungs-Pol (12b) aufweisen, mit jeweiligen Querzweigen (14), wobei jeweils zwei benachbarte Kondensatorstufen (10-n) zwischen dem ersten Pol (12a) der vorhergehenden und dem zweiten Pol (12b) der nachfolgenden Kondensatorstufe (10-n) durch einen der Querzweige (14) verbunden sind, wobei jeder der Querzweige (14) eine Funkenstrecke (18) enthält, enthält mindestens einen im Innenraum (6) angeordneten, dichten Gasraum (20) für ein Isoliergas (22) für die Funkenstrecken (18), der wenigstens zwei der Funkenstrecken (18) beinhaltet, wobei alle Funkenstrecken (18) in einem jeweiligen Gasraum (20) angeordnet sind, wobei der Innenraum (6) einen dichten Fluidraum (24) für ein Kühlfluid (26) für den Marx-Generator (8) enthält, und wenigstens einen im Innenraum (6) angeordneten Grundträger (28), der den Gasraum (20) teilweise umgrenzt, wobei wenigstens eine der Funkenstrecken (18) durch zwei Polkörper (30a,b) gebildet ist, die je eine Elektrode (32a,b) der Funkenstrecke (18) enthalten, wobei zur Bildung der Funkenstrecke (18) beide Polkörper (30a,b) an dem Grundträger (28) befestigt sind und dadurch der Gasraum (20) vollständig umgrenzt ist.

## Beschreibung

Die Erfindung betrifft eine Marx-Anordnung mit einem Marx-Generator in einem Gehäuse, wobei der Marx-Generator Funkenstrecken aufweist.

Aus der Praxis ist bekannt, dass Marx-Generatoren bisher in linearer Anordnung gebaut wurden. Diese Marx-Generatoren wurden in einem Gehäuse untergebracht, das entweder vollständig gasgefüllt war, damit war eine sehr kompakte und niederinduktive Bauform möglich. Alternativ wurde in den Gehäusen mit linearen Marx-Generatoren eine gasgefüllte Funkenstreckenröhre als eigene Baugruppe integriert sowie der Bauraum um die restlichen Komponenten mit hochspannungsisolierender Flüssigkeit gefüllt. Dies hatte aber einen deutlichen Zuwachs an Durchmesser und Baulänge zur Folge, gleichbedeutend mit höherer Induktivität am Marx-Generator bzw. dessen Leitungen zum Abführen der erzeugten Marx-Spannung.

Aufgabe der vorliegenden Erfindung ist es, Verbesserungen in Bezug auf eine Marx-Anordnung vorzuschlagen.

Die Aufgabe wird gelöst durch eine Marx-Anordnung gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Die Marx-Anordnung enthält ein Gehäuse: Das Gehäuse umgibt einen Innenraum des Gehäuses. Die Marx-Anordnung enthält einen Marx-Generator. Der Marxgenerator ist im Innenraum, also innerhalb des Gehäuses angeordnet. Der Marx Generator ist an sich in fachüblicher Weise aufgebaut und enthält diesbezüglich mehrere Kondensatorstufen, die - im Sinne eines Marx-Generators - beim Laden parallel und beim Entladen in Reihe geschaltet sind. Insofern sind die Kondensatorstufen durchnummerierbar als z.B. Kondensatorstufe 1, 2, ..., N. Jede der N Kondensatorstufen weist jeweils mindestens einen ersten Spannungs-Pol und einen zweiten Spannungs-Pol auf. Im Betrieb des Marx-Generators liegt an den ersten Polen z.B. positives Hochspannungspotential +HV an, an den zweiten Polen negatives Hochspannungspotential -HV. Zwischen den beiden Polen liegt im Betrieb dann die Gesamtspannung der jeweiligen Kondensatorstufe an. Insbesondere bilden die Pole in Richtung einer Längsachse gegenüberliegende Längsenden der jeweiligen Kondensatorstufe.

In ebenso fachüblicher Weise enthält der Marx-Generator Querzweige. Jeweils zwei benachbarte Kondensatorstufen sind durch einen der Querzweige verbunden. Der Querzweig führt jeweils vom ersten Pol einer vorhergehenden zum zweiten Pol einer nachfolgenden Kondensatorstufe bzw. verbindet er diese beiden Pole (oder umgekehrt jeweils den zweiten Pol mit dem ersten Pol). "Nachfolgend" bezieht sich hierbei auf die entsprechende Abfolge der Kondensatorstufen in der Reihenschaltung, im obigen Beispiel also auf die Reihenfolge 1, 2, ..., N.

In fachüblicher Weise sind im Marxgenerator alle ersten Spannungspole über Ladeimpedanzen in Reihe geschaltet. Ebenso sind alle zweiten Spannungspole über Ladeimpedanzen in Reihe geschaltet. Auf diese Weise wird der Marx-Generator zwischen den jeweils gleichen Potentialen aufgeladen. Die Querzweige stellen dabei Leerläufe dar. Insofern sind die Kondensatorstufen im Ladezustand des Marxgenerators parallel geschaltet. Die oben genannte "Reihenschaltung" der Kondensatorstufen bezieht sich im Gegensatz hierzu jedoch auf den - diesbezüglich als wesentlich betrachteten - Entladevorgang durch die leitenden bzw. kurzgeschlossenen Querzweige. Die Ladeimpedanzen wirken dabei wie ein jeweiliger Leerlauf.

Um den entsprechenden Leerlauf bei Lade- und Kurzschluss beim Entladevorgang und damit die Reihenschaltung herzustellen, enthält jeder der Querzweige eine Funkenstrecke, die bei ihrem Durchbruch kurzschließt.

Die Marxanordnung enthält mindestens, insbesondere genau, einen Gasraum. Der oder die Gasräume sind im Innenraum angeordnet und dicht ausgeführt. "Dicht" bedeutet dabei, dass der Gasraum vom restlichen Innenraum bzw. einer Umgebung der Marxanordnung / des Gehäuses gasdicht abgetrennt bzw. abgeteilt ist. Der Gasraum dient zur Aufnahme eines Isoliergases für die Funkenstrecken bzw. ist in einem Fertig- oder Betriebszustand mit Isoliergas gefüllt. Im Betrieb ist dadurch die Überschlagspannung der Funkenstrecken gegenüber z.B. Luft erhöht. Dies führt in fachüblich bekannter Weise zu kleineren Funkenstrecken mit niedrigeren Induktivitäten bei gleicher Durchbruchspannung. Der Gasraum bzw. jeder der Gasräume beinhaltet wenigstens zwei der Funkenstrecken. Alle Funkenstrecken der Querzweige des Marxgenerators sind in einem jeweiligen Gasraum, insbesondere in dem einzigen Gasraum, angeordnet. In jedem der Gasräume sind alle Funkenstrecken in Bezug auf das Isoliergas kommunizierend miteinander verbunden, d.h. Gas kann zwischen den Funkenstrecken in den jeweiligen Gasräumen ausgetauscht werden.

Der Innenraum enthält weiterhin einen Fluidraum, der dicht ausgeführt ist. "Dicht" ist auch hier so zu verstehen, dass der Fluidraum gegenüber seiner Umgebung, insbesondere dem Außenraum und den Gasraum fluiddicht abgetrennt bzw. abgeteilt ist. Der Fluidraum dient zur Aufnahme eines Kühlfluids für den Marx-Generator bzw. ist in dem Fertig- oder Betriebszustand mit Kühlfluid gefüllt. Im Betrieb ist dadurch der gesamte Marxgenerator bzw. sämtliche im Gehäuse vom Kühlfluid umgebenen oder umströmten Komponenten gegenüber z.B. einer Gasfüllung besser gekühlt.

Die Marxanordnung enthält wenigstens einen, insbesondere genau einen Grundträger. Der Grundträger ist im Innenraum angeordnet. Der Grundträger umgrenzt den bzw. jeden der Gasräume teilweise, also nicht vollständig. Mit anderen Worten bildet der Grundträger nur einen Teil der den Gasraum umgebenden Wandung. "Teilweise umgrenzen" ist hier so zu verstehen, dass der Gasraum durch den Grundträger alleine nicht vollständig umgrenzt ist. Es verbleibt eine Öffnung, welche noch, zum Beispiel durch einen Deckel oder ein anderes Strukturteil (insbesondere Polkörper, siehe unten. Ein Leiter des Querzweiges soll hier nicht gemeint sein), zu verschließen ist, um den Gasraum vollständig zu umgrenzen. Insofern bilden Deckel oder anderes Strukturteil den restlichen Bereich der Wandung, welche dann den Gasraum vollständig umgrenzt. Ein solcher Deckel oder ein solches Strukturteil bildet mit anderen Worten dann den noch fehlenden Teil der Wandung des Gasraumes. Auch kann sich der Gasraum in das weitere Strukturteil hinein erstrecken / fortsetzen. Dann umgrenzt auch das Strukturteil einen Teilraum des Gasraumes.

Wenigstens eine, insbesondere mehrere oder alle, der Funkenstrecken ist durch zwei Polkörper gebildet. Jeder der beiden Polkörper enthält eine der beiden Elektroden der Funkenstrecke; insbesondere auch einen von der jeweiligen Elektrode wegführenden Abschnitt / Leiter des Querzweiges. Zur Bildung der Funkenstrecke sind beide Polkörper an dem Grundträger befestigt. Dadurch sind die Elektroden dann zueinander fixiert, so dass sich die Funkenstrecke zwischen ihnen ausbildet.

Die Polkörper sind also vom Grundträger verschiedene Bauteile, die insbesondere an diesem befestigbar und in einem Montagezustand tatsächlich befestigt sind. Erst durch das Befestigen bzw. Anbringen der Polkörper am Grundträger ist bzw. wird der Gasraum vollständig umgrenzt. Insofern bilden die Polkörper eines der oben genannten Strukturteile, die einen jeweiligen weiteren Abschnitt der Wandung des Gasraumes bilden bzw. beitragen.

Wenigstens einer der Gasräume, insbesondere der einzige Gasraum, enthält insbesondere mindestens zwei Gasanschlüsse, die aus dem Gehäuse heraus führen. So kann der Gasraum an eine Gasversorgung für Isoliergas angeschlossen werden, um den Gasraum beispielsweise zu füllen, insbesondere jedoch mit Isoliergas zu durchströmen.

Der Fluidraum enthält insbesondere ebenfalls mindestens zwei Fluidanschlüsse, die aus dem Gehäuse heraus führen. So kann der Fluidraum an eine Fluidversorgung für Kühlfluid angeschlossen werden, um den Fluidraum beispielsweise zu füllen, insbesondere jedoch mit (in einem Kühlkreislauf rückgekühltem) Kühlfluid zu durchströmen. Wenigstens einer der Grundträger, insbesondere der einzige Grundträger, ist insbesondere einteilig, z.B. als Vollmaterialblock, z.B. aus Kunststoff, ausgeführt.

Gemäß der Erfindung ergibt sich ein kühlbarer, niederinduktiver Koaxial-Marx. Dies gilt insbesondere, wenn dieser hinsichtlich seiner Kondensatorstufen sinngemäß entsprechend der nachveröffentlichten DE 10 2021 004 466.5 (Anmeldetag DPMA: 02.09.2021, Titel: "Pulsgenerator für einen HPEM-Puls") ausgeführt ist. D.h., wenn die Kondensatoren in Form von Kondensatorstufen auch vorliegend räumlich entlang einer Verlaufslinie angeordnet sind, an deren beiden Enden sich jeweils einer der Ausgangspole für die Marxspannung befindet, wobei der Abstand zwischen den Ausgangspolen kleiner als die Längsausdehnung des Marx-Generators entlang der Verlaufslinie ist. Das grundlegende Prinzip einer solchen Anordnung entlang einer Verlaufslinie (Kreis, S-Form, Zick-Zack) ist in der DE 10 2021 004 466.5 insbesondere anhand der Figuren 2-5 und der zugehörigen Beschreibung erläutert. Der diesbezügliche Offenbarungsgehalt der DE 10 2021 004 466.5 wird daher in die vorliegende Anmeldung aufgenommen, sofern dies nicht im Widerspruch zur vorliegenden Anmeldung, insbesondere zu der vorliegenden Ergänzung um den Gasraum und den Fluidraum, steht. Der dort vorgeschlagene Resonator muss nicht zwangsweise übernommen werden; entscheidend ist nur die strukturelle Anordnung des Marx-Generators.

Der niederinduktive, entlang der Verlaufslinie angeordnete (Koaxial-)Marx-Generator der DE 10 2021 004 466.5 kann insbesondere vollständig gasgefüllt sein (dessen Gehäuse 54) und damit eventuell nicht für längeren Betrieb geeignet sein. In dem vorliegend um den Gasraum und den Fluidraum ergänzten entsprechenden (Koaxial-)Marx-Generator wird ein Gasraum derart integriert, dass insbesondere die Kondensator- und Widerstandsbaugruppen (Kondensatorstufen, Ladeimpedanzen) über ein Fluid in Form einer hochspannungs-isolierenden Flüssigkeit in einem Fluidraum bei annähernd gleicher Baugröße gekühlt betrieben werden können.

Gemäß der Erfindung ergibt sich eine Erweiterung der Betriebszeit insbesondere eines niederinduktiven (Koaxial-)Marx-Generators, ohne gleichzeitig dessen Vorteile der geringen Baugröße und der (ggf. um den Resonator angeordneten) Bauform negativ zu beeinflussen. Würde der gekühlte Generator deutlich größer bauen, stünde dies dem erzielten Spannungsgewinn des Marx-Generators (ggf. Feldstärkegewinn des Resonators) entgegen.

Die Erfindung beruht auf der Überlegung, dass in der Praxis bisher Marx-Generatoren in linearer Anordnung gebaut wurden. Diese wurden entweder vollständig gasgefüllt, damit war eine sehr kompakte und niederinduktive Bauform möglich. Die niederinduktive Bauform führt bei entsprechender Anwendung zu einem schnelleren Umladen der Hochspannung vom Marx-Generator in einen von diesem gespeisten Resonator. Damit werden höhere Ladespannungen des Resonators vor dem Zünden der Funkenstrecke des Resonators erreicht, was wiederum höhere vom Resonator abgestrahlte Feldstärken ergibt.

Alternativ wurde in den linearen Marx-Generatoren eine gasgefüllte Funkenstreckenröhre als eigenen Baugruppe integriert sowie der Bauraum um die restlichen Komponenten (im Wesentlichen die Kondensatoren und Widerstandseinheiten) mit hochspannungsisolierender Flüssigkeit gefüllt. Dies hatte aber einen deutlichen Zuwachs an Durchmesser und Baulänge zur Folge, gleichbedeutend mit höherer Induktivität.

Mit solchen flüssigkeitsgefüllten Marx-Generatoren kann bei entsprechender Anwendung die Ladespannung nur relativ langsam an den Resonator transferiert werden. In der Folge zündet die Funkenstrecke des Resonators bei kleinerer Spannungsamplitude, und die abgestrahlte Feldstärke ist geringer als bei Einsatz der kleineren, gasgefüllten Marx-Generatoren mit niederinduktiverer Charakteristik.

Die Erfindung beruht weiterhin auf folgender Erkenntnis: Der Einfluss der Umladegeschwindigkeit, mit der eine Überspannung über der eigentlichen DC-Durchbruchsspannung an eine Funkenstrecke (wie in einem Resonator verbaut) beaufschlagt wird, auf die Amplitude der Zündspannung ist als sogenanntes Zeit-Flächengesetz nach Kind aus dem Jahr 1957 bekannt. Eine höhere Zündspannung der Funkenstrecke im Resonator impliziert eine höhere abgestrahlte Feldstärke. Dies sind die physikalischen Grundlagen dieser Leistungssteigerung aus der Gasentladungsphysik.

Durch die Lehre der o.g. DE 10 2021 004 466.5 können diese Grundlagen in HPEM-Resonatoren bzw. der konkreten Umsetzung in der niederinduktiven Gestaltung von Marx-Generatoren, welche an die Resonatoren als Last elektrisch und geometrisch angepasst sind, genutzt werden. Der in der DE 10 2021 004 466.5 vorgeschlagene Marx-Generator verfügt jedoch nicht über eine ausreichende Kühlmöglichkeit und stellt daher eine nicht langzeitbetriebsfeste Ausführung dar.

Die Erfindung beruht weiterhin auf der Erkenntnis, dass das bisher aus der Praxis bekannte Design von Funkenstreckenröhren von linear gebauten Marx-Generatoren für niederinduktive, koaxiale Marx-Generatoren nicht oder nur schwer umsetzbar ist.

Diese bisherigen aus der Praxis bekannten Funkenstreckenröhren sind als zylindrische Wickelkörper bzw. Druckkörper ausgeführt, die für eine lineare Anordnung geeignet sind, jedoch nicht für die koaxiale bzw. kreisförmige, S-förmige usw. Anordnung, wie sie in der DE 10 2021 004 466.5 vorgeschlagen wird.

Gemäß der Erfindung kann der bisherige Zielkonflikt überwunden werden: Dieser besteht zwischen einerseits entweder kleinen, kompakten, ausschließlich gasgefüllten und damit nicht dauerbetriebsfesten Marx-Generatoren für hohe Feldstärken des angeschlossenen Resonators. Versus andererseits flüssigkeitsgefüllten, damit dauerbetriebsfesten, jedoch großen, höher induktiven und damit weniger Feldstärke erzeugenden Marx-Generatoren.

Gemäß der Erfindung ergibt sich insbesondere eine niederinduktive und als koaxial bezeichnete, eigentlich ringförmige Konfiguration eines Marxgenerators, die einen frei gestaltbaren, - in fachüblichen Grenzen - beliebig formbaren Gasraum mit baugrößenreduzierenden, außenliegenden Hochspannungs-Isolatoren ergibt (siehe unten). Damit ergibt sich bei annähernd gleicher Baugröße ein kühlbarer Marx-Generator, der gleichzeitig die niederinduktiven Vorteile der geringen Baugröße und Bauform beibehält.

In einer bevorzugten Ausführungsform umgrenzt wenigstens einer der Polkörper einen Teil des Gasraum. Mit anderen Worten bildet der Körper nicht nur einen fehlenden Teil der Wandung des Gasraums, wie oben erläutert, sondern der Gasraum setzt sich tatsächlich bis in den Polkörper hinein fort. Der Gasraum erstreckt sich also sowohl im Grundträger als auch im Polkörper. Ein entsprechender Polkörper bietet unter anderem Vorteile hinsichtlich der elektrischen Isolationsmöglichkeit der Funkenstrecken.

In einer bevorzugten Variante dieser Ausführungsform enthält wenigstens einer der Polkörper einen sich entlang einer Polachse erstreckenden topfförmigen Isolator. Mit anderen Worten folgt der Isolator topfförmig einer geraden Kreiszylinderform mit Boden. Der Polkörper enthält weiterhin einen Leiter, der entlang der Polachse auch zumindest teilweise im Isolator verläuft. Der Leiter verläuft also im topfförmig vom Isolator umgrenzten Innenraum des Polkörpers. Der Leiter bildet einen Abschnitt des Querzweiges. Der Leiter weist an seinem Freiende, also an der der Topföffnung, nicht dem Boden des Topfes, zugewandten Seite, die Elektrode auf. Der Leiter läuft also insbesondere ein Stück außerhalb des Isolators, durchsetzt dann insbesondere den Boden der Topfform und verläuft sodann innerhalb des Isolators (Wand der Topfform), bis er an der Elektrode endet. Auch hier ergeben sich Vorteile hinsichtlich der elektrischen Isolationsmöglichkeit der Funkenstrecken.

Insbesondere weist der Isolator im Topfinneren liegende bzw. zu diesem Innenraum hin weisende wegverlängernde Rippen auf. Diese erstrecken sich insbesondere quer zur Polachse bzw. der Erstreckungsrichtung des Leiters.

Die Polachse bzw. ein der Topform entsprechender Kreiszylinder verläuft insbesondere parallel zu einer Längsachse des Grundträgers (im Montagezustand der Polkörper an diesem), der Kondensatorstufen bzw. Kondensatoren bzw. des Gehäuses bzw. des Marx-Generators bezogen auf dessen Gesamtanordnung (Längsachse insbesondere quer zur Ebene, in welcher die Verlaufslinie gemäß DE 10 2021 004 466.5 verläuft).

In einer bevorzugten Ausführungsform ist wenigstens einer der Polkörper anhand einer Gewindepaarung am bzw. im Grundträger befestigt, indem er also mit Hilfe von zueinander passenden Gewinden dort verschraubt ist. Der Polkörper enthält also ein (insbesondere Außen-)Gewinde, der Grundträger ein korrespondierendes Gegengewinde. So ist der Polkörper besonders einfach am Grundträger zu befestigen bzw. anzubringen. Auch ein entstehender Gasraum kann so im Bereich des Gewindes besonders gut abgedichtet werden.

In einer bevorzugten Ausführungsform sind die beiden Polkörper wenigstens einer, insbesondere aller, der Funkenstrecke bzw. eines Querzweiges an zwei gegenüberliegenden Seiten des Grundträgers an diesem befestigt. So kann besonders einfach eine Funkenstrecke eines Querzweiges und ein dazugehöriger Gasraum geschaffen werden.

In einer bevorzugten Ausführungsform weist wenigstens einer, insbesondere alle, der Gasräume jeweils eine Funkenkammer pro Funkenstrecke auf, wobei die Funkenkammern durch vergleichsweise (im Vergleich zu den Dimensionen der Funkenkammer) kleine (insbesondere bezüglich deren Querschnitt klein dimensionierte) Verbindungskanäle im Grundträger verbunden sind. So ergibt sich eine Reihe von zusammenhängenden Funkenkammern, die zum Austausch von Isoliergas durch Verbindungskanäle verbunden sind. Entsprechende Strukturen für passende Polkörper lassen sich in Grundträgern besonders einfach herstellen.

In einer bevorzugten Variante dieser Ausführungsform sind für wenigstens eine, insbesondere alle, der Funkenstrecken zwei Aufnahmen für die Polkörper in den Grundträger eingebracht. Weiterhin ist eine jeweilige Funkenkammer in Form einer die Aufnahmen verbindenden Durchgangsöffnung in den Grundträger eingebracht. Im Grundträger sind die Verbindungskanäle für benachbarte Funkenkammern durch von außen (also von außerhalb des Grundträgers) schräg einbringbare Durchbrechungen, insbesondere Bohrungen geschaffen. In dieser Ausführungsform ist der Grundträger insbesondere ein Vollmaterialblock. Dies erlaubt eine besonders einfache Ausführung des Grundträgers, vor allem bei der Schaffung der Funkenkammern und Verbindungskanäle.

In einer bevorzugten Ausführungsform ist wenigstens eine, insbesondere mehrere oder alle, der Kondensatorstufen am Grundträger befestigt. So entsteht eine mechanisch besonders stabile Vorrichtung mit Hilfe des Grundträgers.

In einer bevorzugten Variante dieser Ausführungsform ist wenigstens eine, insbesondere mehrere oder alle, der Kondensatorstufen außerhalb des Gasraumes am Grundträger befestigt. "Außerhalb" heißt, dass kein Strukturteil der Kondensatorstufe den Gasraum in derart durchdringt oder in diesen eindringt, dass eine Abdichtung des Gasraumes an dieser Stelle notwendig würde. Mit anderen Worten findet keinerlei Berührung zwischen Gasraum und Kondensatorstufe statt. Die Befestigung der Kondensatorstufen am Grundträger muss damit nicht gegenüber dem Gasraum abgedichtet werden.

In einer bevorzugten Ausführungsform ist der Grundträger mehrteilig aufgebaut. Der Grundträger enthält ein Kernteil sowie mindestens einen gasdicht auf das Kernteil aufsetzbaren Deckel. Der Gasraum ist bzw. wird dann sowohl durch das Kernteil als auch durch mindestens einen, insbesondere zwei, der Deckel begrenzt. So lassen sich besonders variantenreiche Grundträger bzw. Gasräume einfach konstruieren und ausführen. Zwischen Kernteil und Deckel ist insbesondere eine Dichtung vorgesehen.

In einer bevorzugten Variante dieser Ausführungsform ist mindestens einer, insbesondere mehrere oder alle der Polkörper an einem der Deckel befestigt. Insbesondere ist der entsprechende Polkörper ausschließlich am Deckel befestigt. Alternativ oder zusätzlich ist mindestens eine der Kondensatorstufen am Kernteil befestigt. Insbesondere erfolgt die Befestigung jedoch am Kernteil und am Deckel. Insbesondere dient diese Befestigung zugleich der Halterung des Deckels am Kernteil. Die "Befestigung der Kondensatorstufe" kann insbesondere bedeuten, dass zumindest eine Komponente der Kondensatorstufe, z. B. einer von mehreren Kondensatoren der Kondensatorstufe, entsprechend befestigt ist. Auch kann ein Zwischenstück zwischen zwei Kondensatoren, z.B. eine Verbindungsleitung / -stange / -leiter am Grundträger befestigt sein und so die Kondensatoren nur über diese Komponent mittelbar am Grundträger befestigt sein. Auch so lassen sich konstruktiv besonders günstige Varianten von Marx-Anordnungen schaffen.

In bevorzugten Ausführungsform können die Kondensatorstufen neben dem ersten und zweiten Pol auch weitere Pole - insbesondere für Zwischenpotentiale zwischen den Polpotentialen - enthalten.

In einer bevorzugten Ausführungsform enthält wenigstens eine, insbesondere mehrere oder alle, der Kondensatorstufen mindestens, insbesondere genau, zwei zwischen erstem und zweitem Spannungs-Pol in Reihe geschaltete Kondensatoren. Zwischen den Kondensatoren befindet sich dann ein jeweiliger dritter Spannungs-Pol. Insbesondere ist der bzw. eine der dritten Spannungs-Pole ein Massepol (Potential 0V im Betrieb); erster und zweiter Spannungs-Pol sind dann Pole für positive und negative Hochspannungspotenziale, insbesondere gleichen Betrags, also +/- HV.

In einer bevorzugten Variante dieser Ausführungsform ist wenigstens eine der Kondensatorstufen mit ihrem dritten Spannungs-Pol am Grundträger befestigt. Der dritte Spannungs-Pol ist dabei insbesondere als Durchkontaktierung des Grundträgers ausgeführt. Insbesondere besteht dabei eine elektrisch leitende Verbindung zwischen drittem Spannungs-Pol und Grundträger. Insbesondere liegen im Betrieb all diese Bauteile mit dem dritten Spannungs-Pol auf Masse. So ergeben sich sowohl konstruktiv als auch elektrisch besonders vorteilhafte Ausführungsformen.

In einer bevorzugten Ausführungsform folgt der Grundkörper einer Verlaufslinie in einer Ebene. Die Verlaufslinie bzw. deren Verlaufsform ist insbesondere eine Ringform um eine Längsachse, eine S-Form, eine Zick-Zack-Form oder eine Kombination hiervon. Mit anderen Worten greift die vorliegende Erfindung damit das grundlegende Konstruktionsprinzip einer solchen Anordnung entlang einer Verlaufslinie in der oben genannten DE 10 2021 004 466.5 auf. Das Gehäuse erstreckt sich dabei insbesondere entlang und ringförmig um eine Längsachse. Die Kondensatorstufen verteilen sich insbesondere ringförmig, aber auch gemäß einer S-Form, einem Zick-Zack-Verlauf, usw. um die Längsachse. Insbesondere weist dann auch der Grundkörper eine entsprechende Form auf bzw. folgt einer derartigen Verlaufslinie. Insbesondere erstrecken sich auch die Kondensatorstufen jeweils parallel in Richtung der Längsachse. Insbesondere sind also die Kondensatorstufen und die Querzweige der Verlaufslinie folgend entlang des Grundträgers angeordnet. Insbesondere sind die Kondensatorstufen und die Querzweige ebenfalls ringförmig um die Längsachse herum verteilt.

In einer bevorzugten Ausführungsform enthält die Marxanordnung einen zumindest teilweise im Gehäuse aufgenommenen, im Betrieb vom Marx-Generator mit Energie versorgten, HF-Resonator. Die Energie wird insbesondere in Form der Marxspannung geliefert. Die Maxanordnung wird dabei insbesondere zu einem Pulsgenerator für einen HPEM-Puls, wie er dem Grunde nach in der o.g. DE 10 2021 004 466.5 erläutert ist.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt.

Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Gemäß einer ersten Ausführungsform wird der Grundkörper als ein nicht ganz geschlossener, zum Beispiel Dreiviertel-, Ring ausgeführt. In ein Kernteil des Grundkörpers wird für jeden der Querzweige bzw. Funkenstrecken eine zum Grundkörper / Kernteil vergleichsweise kleine Druckkammer als z.B. gefräste Außenkontur eingebracht. Diese wird - an zwei gegenüberliegenden Seiten des Kernteils - mit zwei Deckeln verschlossen, die jeweils ("oben" und "unten", also an den gegenüberliegenden Seiten) durch eine jeweilige Dichtung, insbesondere nach Art einer "Zylinderkopf-Dichtung", abgedichtet werden. Eine Dichtlinie bzw. Dichtfläche kann dabei am Kernteil so geführt werden, dass Verbindungen der Kondensatorbaugruppen mit dem Kernteil durch das Kernteil hindurchgeführt bzw. durchkontaktiert werden können, ohne dass der Druckbereich (Gasraum) von Komponenten der Kondensatorbaugruppe durchdrungen wird. Damit werden weitere Dichtstellen am Gasraum, die ansonsten notwendig würden, vermieden. Hochspannungs-Isolatoren für die Querzweige werden insbesondere außen am Grundträger, also im Flüssigkeitsbereich, also im Fluidraum, aufgesetzt, statt diese innen im Grundträger, nämlich im Gasraum, anzuordnen.

In einer zweiten Ausführungsform wird der Grundträger als Vollmaterial-Block in nicht ganz geschlossener, zum Beispiel Dreiviertel-, Ringform ausgeführt. Es werden Gewinde(-bohrungen) für entsprechende, außen am Grundträger liegende, Hochspanungs-Isolatoren in den Vollmaterial-Block eingebracht. Die Polkörper, die auch die Hochspannungsisolatoren beinhalten, werden in den Block eingeschraubt. Die Gasvolumina (Funkenkammern), die sich zwischen eingeschraubten Hochspannungs-Isolatoren im Block ergeben, werden durch schräge, von außen (also von außerhalb des Blocks) anfertigbare Bohrungen verbunden.

In beiden Fällen stellen Teile der Polkörper Hochspannungsisolatoren dar, die gleichzeitig die Halterungen der Funkenstreckenelektroden (einschließlich Leiter, Teil des Querzweiges, mit Elektrode) sind.

Der Gasraum (bzw. der Grundträger) kann beispielsweise in einer offenen, also nicht ganz geschlossenen Ring-Form konzipiert werden. In diesem Grundkörper / Kernteil bzw. Ring werden von beiden Seiten Gewinde für die Polkörper bzw. deren Hochspannungsisolatoren eingebracht. Die gegenüberliegenden Gewinde werden mit einer Kernbohrung verbunden, so dass sich automatisch eine Funkenkammer als Teil des Gasraums zwischen den Elektroden der Polkörper ergibt. Die einzelnen Funkenkammern in Form von Teil-Gasräumen werden über schräg von außen (außerhalb des Grundträgers) angebrachte Bohrungen zu einem gemeinsamen Gasraum verbunden.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen, jeweils in einer schematischen Prinzipskizze:
- Figur 1: eine Marx-Anordnung symbolisch in perspektivischer Schrägansicht,
- Figur 2: den Marx-Generator aus Figur 1 im Teilschnitt,
- Figur 3: den Grundträger aus Figur 1,
- Figur 4: den Grundträger aus Figur 1 im Teilschnitt,
- Figur 5: einen Ausschnitt aus einer alternativen Marx-Anordnung in Draufsicht (Blickrichtung des Pfeils V in Figur 6),
- Figur 6: die Marx-Anordnung aus Figur 5 in Seitenansicht (Blickrichtung des Pfeils VI in Figur 5).

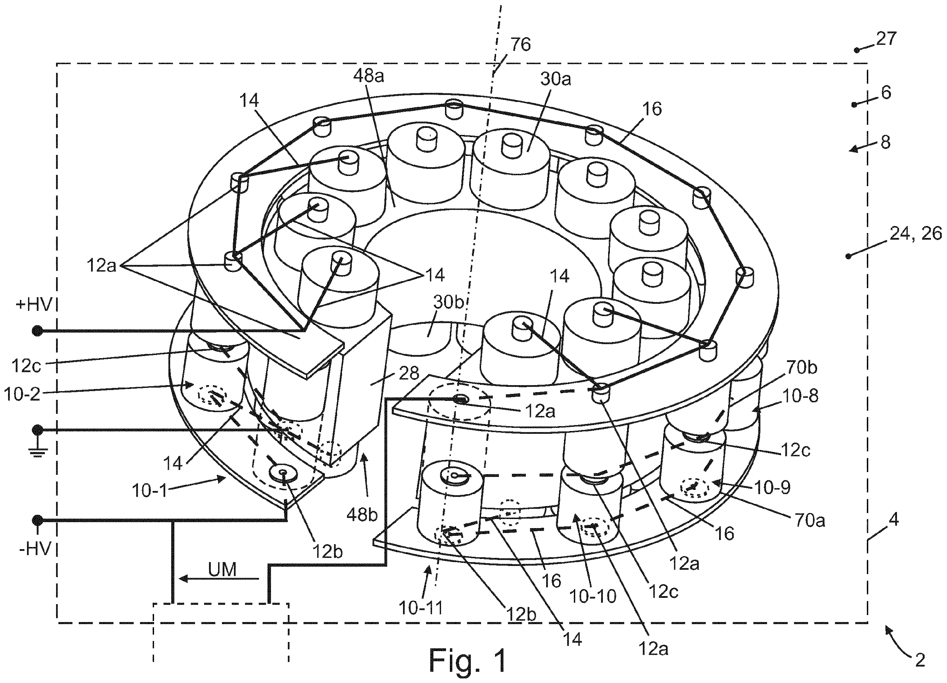

Figur 1 zeigt eine Marxanordnung 2 mit einem hier nur symbolisch angedeuteten Gehäuse 4, das einen Innenraum 6 umgibt. Im Innenraum 6 ist ein Marx-Generator 8 angeordnet. Bezüglich seines Grundaufbaus in elektrischer Hinsicht ist der Marxgenerator 8 fachüblich aufgebaut. Insofern umfasst dieser eine Anzahl N von elf Kondensatorstufen 10-n, die hier von n=1 bis n=N=11 durchnummeriert sind (also "10-1", "10-2", ..., "10-10", "10-11"). Jede der Kondensatorstufen 10-n weist jeweils einen ersten Spannungs-Pol 12a und einen zweiten Spannungs-Pol 12b auf.

Der Marxgenerator 8enthält außerdem zehn Querzweige 14. Jeweils zwei benachbarte Kondensatorstufen 10-n und 10-n+1 (n=1...10) sind über je einen der zehn Querzweige 14 verbunden. Genauer gesagt, führt jeweils ein Querzweig 14 von dem ersten Spannungs-Pol 12a einer vorhergehenden Kondensatorstufe 10-n zum zweiten Spannungs-Pol 12b der nachfolgenden Kondensatorstufe 10-n+1. In der Figur sind die Querzweige teils und nur für einzelne Querzweige durch symbolische Verbindungslinien angedeutet. Beispielsweise führt vom Pol 12 A der Kondensatorstufe 10-1 eine erste elektrische Verbindung über den ersten Querzweig 14 zum Spannungs-Pol 12b der Kondensatorstufe 10-2. Ein zehnter Querzweig 14 führt vom ersten Pol 12a der Kondensatorstufe 10-10 zum zweiten Pol 12b der Kondensatorstufe 10-11.

Die ersten Pole 12a je zweier benachbarter Kondensatorstufen 10-n sind über Ladeimpedanzen 16 (teilweise der Übersichtlichkeit halber nicht dargestellt oder nur gestrichelt angedeutet) in Reihe geschaltet und werden im Betrieb, insbesondere zum Aufladen, mit einem positiven Hochspannungspotenzial +HV versorgt. Ebenso sind die zweiten Pole 12b je zweier benachbarter Kondensatorstufen 10-n über Ladeimpedanzen 16 in Reihe geschaltet und werden im Betrieb mit einem negativen Hochspannungspotenzial -HV versorgt. Insofern ergibt sich im Betrieb zum Aufladen der Kondensatorstufen 10-n deren Parallelschaltung, denn die Querzweige 14 bilden hier - vereinfacht gesprochen - elektrische Leerläufe, die Ladeimpedanzen 16 elektrische Kurzschlüsse.

Im Entladefall bzw. zur Erzeugung einer Marxspannung UM wirken die Ladeimpedanzen 16 als elektrische Leerläufe, die Querzweige 14 als elektrische Kurzschlüsse, so dass dann die elf Kondensatorstufen 10-n in Reihe geschaltet sind. Die Marxspannung UM ergibt sich zwischen dem zweiten Pol 12b der ersten Kondensatorstufe 10-1 und dem ersten Pol 12a der letzten Kondensatorstufe 10-11 als - vereinfacht - N mal die Ladespannung der jeweiligen Kondensatorstufen 10-n, hier also UM = N * 2 * HV. Aus diesem Grund werden die Kondensatorstufen 10-n im Marxgenerator 8 als "in Reihe geschaltet" bezeichnet.

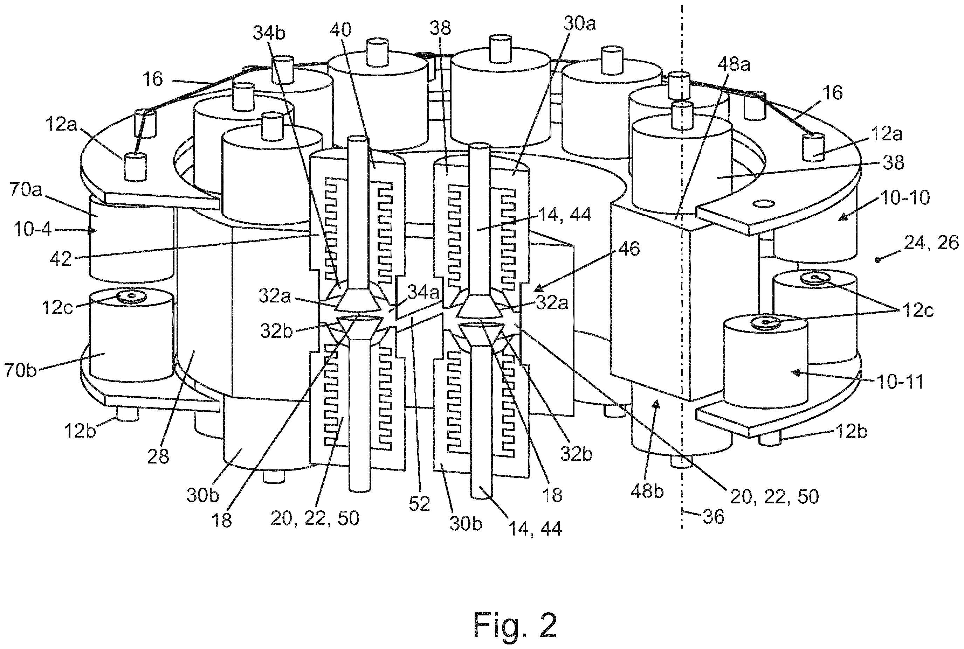

Figur 2 zeigt einen Teilschnitt durch den Marxgenerator 8 aus Figur 1. Hier ist erkennbar, dass jeder der Querzweige 14 eine Funkenstrecke 18 enthält. Durch das Zünden bzw. Durchschalten der Funkenstrecke 18 wird der jeweilige Querzweig 14 von seinem Leerlauf- in seinen Kurzschluss-Zustand gebracht.

Die Marxanordnung 2 enthält einen Gasraum 20. Dieser ist im Innenraum 6 angeordnet und dicht ausgeführt, d.h. gasdicht gegenüber dem restlichen Innenraum 6 ausgeführt. Im Betrieb bzw. im Fertigstellungszustand des Marx-Generators 8 ist im Gasraum 20 ein Isoliergas 22 für die Funkenstrecke 18 enthalten. Der Gasraum 20 beinhaltet im Beispiel alle zehn Funkenstrecken 18 aller zehn Querzweige 14. Das Isoliergas 22 erhöht die Durchbruchspannung für die Funkenstrecken 18, so dass diese bei gleicher Durchbruchspannung kürzer und damit im Kurzschlussfall mit niedrigerer Induktivitäten ausgeführt werden können als bei einer Funkenstrecke in Luft. Anschlusskanäle, die vom Gasraum 20 nach außerhalb des Gehäuses 4 führen, dienen zum Befüllen bzw. Durchströmen des Gasraumes 20 und sind in den Figuren nicht dargestellt.

Die Marxanordnung 2 weist weiterhin einen Fluidraum 24 im Innenraum 6 auf, der im Betrieb ein Kühlfluid 26 enthält. Der Fluidraum 24 ist fluiddicht ausgeführt, d.h. gegenüber dem restlichen Innenraum 6 bzw. einem Außenraum 27, der das Gehäuse 4 umgibt, insbesondere auch gegenüber dem Gasraum 20, fluiddicht ausgeführt. Das Kühlfluid 26 kühlt im Betrieb den Marxgenerator 8. Hierzu durchströmt es das Gehäuse 4 mit Hilfe von nicht dargestellten Öffnungen im Gehäuse 4 und einem daran angeschlossenen Kühlkreislauf, der sich außerhalb des Gehäuses über ein Kühlaggregat fortsetzt.

Die Marxanordnung 2 enthält einen Grundträger 28, der ebenfalls im Innenraum 6 angeordnet ist. Der Grundträger 28 umgrenzt den Gasraum 20 zu einem Teil, wie weiter unten näher erläutert wird.

Jede der Funkenstrecken 18 ist durch zwei Polkörper 30a,b gebildet. Jeder der Polkörper 30a,b enthält eine der Elektroden 32a, b der jeweiligen Funkenstrecke 18. Zur Bildung der jeweiligen Funkenstrecke 18 sind die beiden zugehörigen Polkörper 30a,b jeweils am Grundträger 28 befestigt. Erst durch die Polkörper 30a,b bzw. deren Befestigung bzw. Platzierung am Grundträger 28 wird der Gasraum 20 vollständig umgrenzt bzw. verschlossen bzw. abgedichtet.

Mit anderen Worten wird also nur ein Teil 34a einer den Gasraum 20 umgrenzenden Wandung durch den Grundträger 28 gebildet; der restliche Teil 34b dieser Wandung wird durch die Polkörper 30a,b gebildet.

Der Gasraum 20 erstreckt sich dabei auch in die jeweiligen Polkörper 30a,b hinein, so dass diese auch einen Teil des Gasraums 20 umgrenzen, was durch den Teil 34b der Wandung bewerkstelligt ist.

Die Polkörper 30a,b erstrecken sich jeweils entlang einer Polachse 36. Sie enthalten einen topfförmigen Isolator 38, der sich jeweils entlang der Polachse 36 erstreckt. Die Topform wird durch einen im Wesentlichen ebenen und kreisscheibenförmigen Boden 40 sowie einen Hohlzylinder 42 gebildet. Der Hohlzylinder 42 erstreckt sich vom Boden 40 aus entlang der Polachse 36 weg. Die Polkörper 30a,b enthalten einen im Isolator 38 verlaufenden Leiter 44. "Im Isolator" bedeutet, dass dieser - von außen kommend - zunächst den Boden 40 durchsetzt und sodann innerhalb des Isolators 38 bzw. im darin gebildeten Teil des Gasraums 20 verläuft. Der jeweilige Leiter 44 bildet einen Abschnitt des Querzweiges 14 und weist an seinem Freiende die Elektrode 32a oder 32b auf.

Die Polkörper 30a,b sind anhand einer jeweiligen Gewindepaarung 46 am Grundträger 28 befestigt, hier verschraubt. Die Gewindepaarung 46 besteht aus einem jeweiligen, in den Figuren nicht näher dargestellten Außengewinde am Isolator 38, welches mit einem Innengewinde im Grundträger 28 verschraubt ist. Die beiden Polkörper 30a,b zur Bildung einer jeweiligen Funkenstrecke 18 bzw. eines Querzweiges 14 sind jeweils an gegenüberliegenden Seiten 48a,b des Grundträgers 28 befestigt.

Vorliegend besteht der Gasraum 20 aus insgesamt zehn Funkenkammern 50, jeweils einer für jede Funkenstrecke 18 bzw. jeden Querzweig 14 und neun Verbindungskanälen 52. Jeweils zwei im Grundträger 28 benachbarte Funkenkammern 50 sind durch einen der - in Relation zur Größe der Funkenkammer 50 - vergleichsweise kleinen Verbindungskanal 52 verbunden.

Die Marxanordnung 2 enthält weiterhin einen, hier nur symbolisch angedeuteten HF-Resonator 100, der hier teilweise in das Gehäuse 4 aufgenommen ist, und der im Betrieb vom Marxgenerator 8 mit Energie, nämlich der Marxspannung UM, versorgt ist. In einer realen Ausführungsform ist z.B. gemäß der DE 10 2021 004 466.5 der HF-Resonator 100 zentral innerhalb des Marxgenerators 8 angeordnet und erstreckt sich entlang und konzentrisch zu einer Längsachse 76 der gesamten Marx-Anordnung 2.

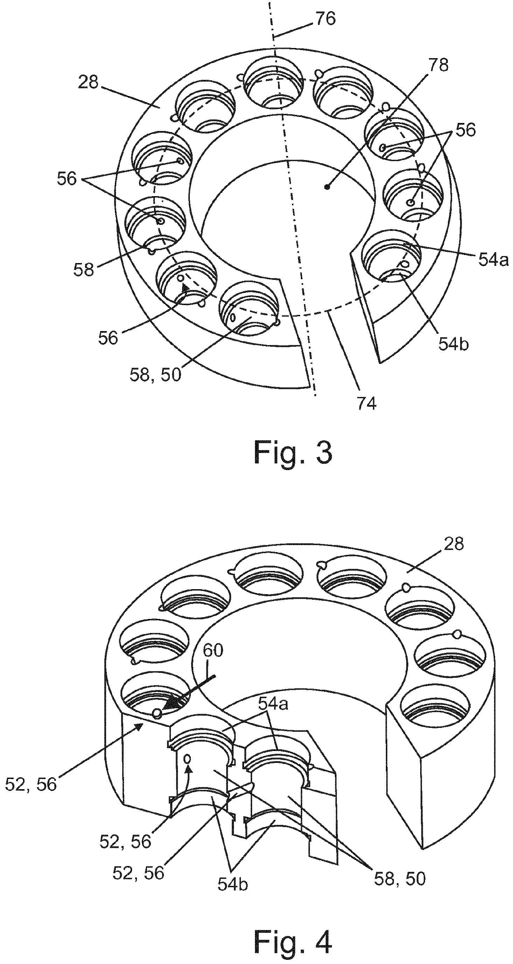

Figur 3 zeigt den Grundträger 28 aus den Figuren 1 und 2 ohne weitere Komponenten in vollständiger Ansicht.

Figur 4 zeigt den entsprechenden Grundträger 28 im Teilschnitt. Für jede der Funkenstrecken 18 bzw. Querzweige 14 sind in den Grundträger 28 zwei Aufnahmen 54a,b eingebracht. Die Aufnahmen 54a,b entsprechenden den bzw. weisen die oben genannten Innengewinde zum Einschrauben der Isolatoren 38 auf. Weiterhin ist für jede der Funkenstrecken 18 bzw. Querzweige 14 in den Grundträger 28 eine Durchgangsöffnung 58 eingebracht. In dieser Durchgangsöffnung 58 wird durch Einschrauben der Polkörper 30a,b in den Grundträger 28 die Funkenkammer 50 gebildet.

Im Grundträger 28 sind weiterhin die Verbindungskanäle 52 durch von außen, d.h. von außerhalb des Grundträgers 28, schräg einbringbare Durchbrechungen 56, hier Bohrungen, geschaffen. Dies ist insbesondere in Figur 4 erkennbar, denn hier (Pfeil 60) ist eine freie Sicht in Bohrrichtung entlang einer der Durchbrechungen 56 durch den Grundträger 28 hindurch möglich. In einer entsprechenden Richtung kann also z.B. durch einfachen Bohren mit Hilfe eines Bohrers die Durchbrechung 56 geschaffen werden.

Der Grundträger 28 ist hier als unterbrochener Ring bzw. Ringabschnitt (entlang einer kreisringförmigen Verlaufslinie 74, siehe unten) aus Kunststoff-Vollmaterial einschließlich der Gewindebohrungen bzw. Innengewinde (Aufnahmen 54a,b) für die Hochspannungs-Isolatoren 38 ausgeführt. Die Kondensatorstufen 10 bzw. deren Kondensatoren 70a,b (siehe unten) liegen bezüglich der Längsachse 76 radial außerhalb des Rings bzw. Grundträgers 28.

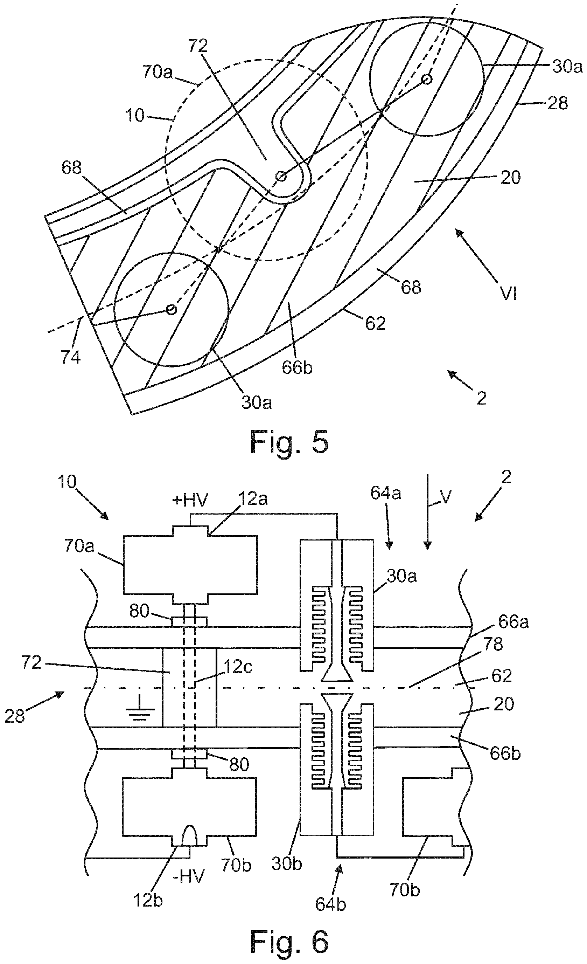

Figur 5 zeigt einen Ausschnitt aus einer alternativen Ausführungsform einer Marxanordnung 2 in Draufsicht (in Richtung des Pfeils V in Figur 6). Nämlich einen Teil des Grundträgers 28 mit einer und einem Teil einer zweiten (Figur 6) Kondensatorstufe 10 und Abschnitte von benachbarten Querzweigen 14 bzw. deren Polkörper 30a,b.

Figur 6 zeigt die entsprechende Marxanordnung 2 in Seitenansicht, nämlich in Richtung des Pfeils VI aus Figur 5.

Die Polkörper 30a,b sind identisch zum Ausführungsbeispiel gemäß der Figuren 1 bis 4 ausgeführt. Vor allem der Grundträger 28 und der Gasraum 20 sind hier jedoch alternativ ausgestaltet. Die ebenfalls alternativen Kondensatorstufen 10 sind hier unmittelbar am Grundträger 28 befestigt. Die Kondensatorstufen 10 sind jedoch außerhalb des Gasraums 20 am Grundträger 28 befestigt. Der Gasraum 20 berührt also an keiner Stelle einen Teil der Kondensatorstufen 10.

Der Grundträger 28 ist hier mehrteilig aufgebaut, enthält nämlich ein Kernteil 62 sowie an dessen gegenüberliegenden Seiten 64a,b einen jeweiligen Deckel 66a,b. In Figur 5 ist der Deckel 66a transparent dargestellt, d.h. Figur 5 zeigt einen Blick auf das Kernteil 62 sowie den darunterliegenden Deckel 66b. Der Gasraum 20 ist in Figur 5 zur Verdeutlichung gestrichelt markiert.

Die Deckel 66a,b sind jeweils gasdicht auf das Kernteil 62 aufgebracht. Hierzu dienen - nach Art einer Zylinderkopfdichtung verlaufende - Dichtungen 68 zwischen Kernteil 62 und jeweiligem Deckel 66a,b. In dieser Ausführungsform sind die Polkörper 30a,b am Grundträger 28 dadurch befestigt, dass der Polkörper 30a ausschließlich am Deckel 66a, der Polkörper 30b ausschließlich am Deckel 66b befestigt ist. Die Kondensatorstufen 10-n ist dagegen sind an den Deckeln 66a,b als auch am Kernteil 62 befestigt. Dies geschieht wie folgt:
Wie übrigens auch alle Kondensatorstufen 10 in den Figuren 1 bis 4 enthält auch hier die Kondensatorstufe 10 zwei zwischen dem ersten Pol 12a auf dem zweiten Pol 12b in Reihe geschaltete Kondensatoren 70a,b. Zwischen den beiden Kondensatoren 70a,b befindet sich ein dritter Spannungs-Pol 12c. Die jeweiligen dritten Spannungspole 12c aller Kondensatorstufen 10-n sind jeweils untereinander elektrisch leitend verbunden und im Ausführungsbeispiel auf Massepotenzial geschaltet.

In den Figuren 5 und 6 ist der dritte Pol 12c als mechanisch stabile und die Kondensatoren 70a,b tragende Durchkontaktierung durch den Grundträger 28 ausgeführt. Die Durchkontaktierung verläuft dabei außerhalb des Gasraumes 20. Hierzu weist der Gasraum 20 am Ort der Kondensatorstufen 10-n jeweilige Einbuchtungen 72 auf, so dass die Durchkontaktierung innerhalb dieser jeweiligen Einbuchtung 72 Platz findet. Auch die Dichtung 68 folgt der jeweiligen Einbuchtung 72, sodass die Durchkontaktierung nicht hinsichtlich des Gasraumes 20 abgedichtet werden muss. Die Durchkontaktierung dient als mechanischer Träger für die jeweilige Kondensatorstufe 10-n bzw. die Kondensatoren 70a,b.

Die Kondensatorstufen 10-n sind also vorliegend mit ihrem dritten Pol12c am Grundträger 28 befestigt. In nicht näher erläuterter Weise dient der Pol 12c bzw. die Durchkontaktierung hier auch zum Anpressen der Deckel 66a,b an dem Kernteil 62 unter Verpressung der Dichtungen 68. Im Ausführungsbeispiel ist dies durch Verschrauben von Muttern 80 auf der Durchkontaktierung bzw. dem Pol 12c in Form einer Gewindestange realisiert.

In allen Beispielen folgt der Grundkörper 28 der hier kreisförmigen Verlaufslinie 74 im Sinne der oben genannten DE 10 2021 004 466.5. Die Verlaufslinie 74 liegt in einer Ebene 78, die senkrecht zu der Längsachse 76 der gesamten Marx-Anordnung 2 verläuft. Auch die Kondensatorstufen 10-n sowie die Funkenstrecken 18 bzw. Querzweige 14 sind entlang dieser Verlaufslinie 74, hier also jeweils ringförmig konzentrisch um die Längsachse 76 herum, angeordnet. Dies führt zu der besonders niederinduktiven Ausführung des Marxgenerators 8, wie in der DE 10 2021 004 466.5 erläutert.

### Bezugszeichenliste

- 2: Marx-Anordnung
- 4: Gehäuse
- 6: Innenraum
- 8: Marx-Generator
- 10-n: Kondensatorstufe (n=1,2,...,11)
- 12a-c: Spannungs-Pol
- 14: Querzweig
- 16: Ladeimpedanz
- 18: Funkenstrecke
- 20: Gasraum
- 22: Isoliergas
- 24: Fluidraum
- 26: Kühlfluid
- 27: Außenraum
- 28: Grundträger
- 30a,b: Polkörper
- 32a,b: Elektrode
- 34a,b: Teil (Wandung)
- 36: Polachse
- 38: Isolator
- 40: Boden
- 42: Hohlzylinder
- 44: Leiter
- 46: Gewindepaarung
- 48a,b: Seite (Grundträger)
- 50: Funkenkammer
- 52: Verbindungskanal
- 54a,b: Aufnahme
- 56: Durchbrechung
- 58: Durchgangsöffnung
- 60: Pfeil
- 62: Kernteil
- 64a,b: Seite (Kernteil)
- 66a, b: Deckel
- 68: Dichtung
- 70a,b: Kondensator
- 72: Einbuchtung
- 74: Verlaufslinie
- 76: Längsachse
- 78: Ebene
- 80: Mutter
- 100: HF-Resonator

- +/-HV: Hochspannungspotenzial
- UM: Marxspannung

## Patentansprüche

1. Marx-Anordnung (2),
- mit einem Gehäuse (4), das einen Innenraum (6) umgibt,
- und mit einem im Innenraum (6) angeordneten Marx-Generator (8),
- mit mehreren in Reihe geschalteten Kondensatorstufen (10-n), die jeweils mindestens einen ersten (12a) und einen zweiten Spannungs-Pol (12b) aufweisen,
- mit jeweiligen Querzweigen (14), wobei jeweils zwei benachbarte Kondensatorstufen (10-n) zwischen dem ersten Pol (12a) der vorhergehenden und dem zweiten Pol (12b) der nachfolgenden Kondensatorstufe (10-n) durch einen der Querzweige (14) verbunden sind,
- wobei jeder der Querzweige (14) eine Funkenstrecke (18) enthält,
- mit mindestens einem im Innenraum (6) angeordneten, dichten Gasraum (20) für ein Isoliergas (22) für die Funkenstrecken (18), der wenigstens zwei der Funkenstrecken (18) beinhaltet, wobei alle Funkenstrecken (18) in einem jeweiligen Gasraum (20) angeordnet sind,
- wobei der Innenraum (6) einen dichten Fluidraum (24) für ein Kühlfluid (26) für den Marx-Generator (8) enthält,
- mit wenigstens einem im Innenraum (6) angeordneten Grundträger (28), der den Gasraum (20) teilweise umgrenzt,
- wobei wenigstens eine der Funkenstrecken (18) durch zwei Polkörper (30a,b) gebildet ist, die je eine Elektrode (32a,b) der Funkenstrecke (18) enthalten, wobei zur Bildung der Funkenstrecke (18) beide Polkörper (30a,b) an dem Grundträger (28) befestigt sind und dadurch der Gasraum (20) vollständig umgrenzt ist.

2. Marx-Anordnung (2) nach Anspruch 1,
**dadurch gekennzeichnet, dass**
wenigstens einer der Polkörper (30a,b) einen Teil des Gasraums (20) umgrenzt.

3. Marx-Anordnung (2) nach Anspruch 2,
**dadurch gekennzeichnet, dass**
wenigstens einer der Polkörper (30a,b) einen sich entlang einer Polachse (36) erstreckenden topfförmigen Isolator (38) enthält, und einen entlang der Polachse (36) zumindest teilweise im Isolator (38) verlaufenden Leiter (44) enthält, der einen Abschnitt des Querzweiges (14) bildet und der an seinem Freiende die Elektrode (32a,b) aufweist.

4. Marx-Anordnung (2) nach einem der vorhergehenden Ansprüche,
**dadurch gekennzeichnet, dass**
wenigstens einer der Polkörper (30a,b) anhand einer Gewindepaarung (46) am Grundträger (28) befestigt ist.

5. Marx-Anordnung (2) nach einem der vorhergehenden Ansprüche,
**dadurch gekennzeichnet, dass**
die beiden Polkörper (30a,b) wenigstens einer der Funkenstrecken (14) an zwei gegenüberliegenden Seiten (48a,b) des Grundträgers (28) an diesem befestigt sind.

6. Marx-Anordnung (2) nach einem der vorhergehenden Ansprüche,
**dadurch gekennzeichnet, dass**
wenigstens einer der Gasräume (20) jeweils eine Funkenkammer (50) pro Funkenstrecke (18) aufweist, wobei die Funkenkammern (50) durch vergleichsweise kleine Verbindungskanäle (52) im Grundträger (28) verbunden sind.

7. Marx-Anordnung (2) nach Anspruch 6,
**dadurch gekennzeichnet, dass**
für wenigstens eine der Funkenstrecken (14) zwei Aufnahmen (54a,b) für deren Polkörper (30a,b) sowie die jeweilige Funkenkammer (50) in Form einer die Aufnahmen (54a,b) verbindenden Durchgangsöffnung (58) in den Grundträger (28) eingebracht sind, und im Grundträger (28) die Verbindungskanäle (52) durch von außen schräg einbringbare Durchbrechungen (56) geschaffen sind.

8. Marx-Anordnung (2) nach einem der vorhergehenden Ansprüche,
**dadurch gekennzeichnet, dass**
wenigstens eine der Kondensatorstufen (10-n) am Grundträger (28) befestigt ist.

9. Marx-Anordnung (2) nach Anspruch 8,
**dadurch gekennzeichnet, dass**
wenigstens eine der Kondensatorstufen (10-n) außerhalb des Gasraumes (20) am Grundträger (28) befestigt ist.

10. Marx-Anordnung (2) nach einem der vorhergehenden Ansprüche,
**dadurch gekennzeichnet, dass**
der Grundträger (28) mehrteilig aufgebaut ist und ein Kernteil (62) sowie mindestens einen gasdicht auf das Kernteil aufsetzbaren Deckel (66a,b) enthält, wobei der Gasraum (20) sowohl durch das Kernteil (62) als auch durch mindestens einen der Deckel (66a,b) begrenzt ist.

11. Marx-Anordnung (2) nach Anspruch 10,
**dadurch gekennzeichnet, dass**
mindestens einer der Polkörper (30a,b) an einem der Deckel (66a,b) befestigt ist und/oder mindestens eine der Kondensatorstufen (10-n) am Kernteil (62) befestigt ist.

12. Marx-Anordnung (2) nach einem der vorhergehenden Ansprüche,
**dadurch gekennzeichnet, dass**
wenigstens eine der Kondensatorstufen (10-n) zwei zwischen erstem (12a) und zweitem Spannungs-Pol (12b) in Reihe geschaltete Kondensatoren (70a,b) enthält, zwischen denen sich ein jeweiliger dritter Spannungs-Pol (12c) befindet.

13. Marx-Anordnung (2) nach Anspruch 12,
**dadurch gekennzeichnet, dass**
wenigstens eine der Kondensatorstufen (10-n) mit ihrem dritten Pol (12c) am Grundträger (28) befestigt ist.

14. Marx-Anordnung (2) nach einem der vorhergehenden Ansprüche,
**dadurch gekennzeichnet, dass**
der Grundkörper (28) einer Verlaufslinie (74) in einer Ebene (78) folgt.

15. Marx-Anordnung (2) nach einem der vorhergehenden Ansprüche,
**dadurch gekennzeichnet, dass**
die Marxanordnung (2) einen zumindest teilweise im Gehäuse (4) aufgenommenen, im Betrieb vom Marx-Generator (8) mit Energie versorgten, HF-Resonator (100) enthält.
